# EUROPEAN PATENT APPLICATION

(11) **EP 3 483 224 A1**
(43) Date of publication of application: **15.05.2019**
(21) Application number: 18204281.2
(22) Date of filing: 05.11.2018
(51) Int. Cl.: C09D 5/32, H01L 21/02

(54) **HOMOGENEOUS COATING SOLUTION AND PRODUCTION METHOD THEREOF**

(30) Priority: 08.11.2017 JP 2017215941
(71) Applicant: Tokyo Ohka Kogyo Co., Ltd., Kawasaki-shi, Kanagawa 211-0012 (JP)
(72) Inventor: LIAO, YuehChun, KANAGAWA, 211-0012 (JP); NAKAMURA, Akimasa, KANAGAWA, 211-0012 (JP)
(74) Representative: Cabinet Plasseraud

(57) **Abstract**

A homogeneous coating solution including: at least one metal or metal compound selected from the group consisting of a group 1 metal, a group 2 metal, a group 1 metal compound and a group 2 metal compound; at least one metal or metal compound selected from the group consisting of a group 13 metal and a group 13 metal compound; a Lewis base solvent; and a Lewis acid.

## Description

### TECHNICAL FIELD

The present invention relates to a homogeneous coating solution and production method thereof, a visible light-absorbing semiconductor layer and production method thereof, and a solar cell and a production method thereof.

Priority is claimed on Japanese Patent Application No. 2017-215941, filed November 8, 2017, the content of which is incorporated herein by reference.

### DESCRIPTION OF RELATED ART

Metal chalcogenide semiconductor materials are attracting many attentions for applications of photovoltaics, photosensor, and photocatalyst due to its strong absorption of visible light and superior electrical properties. For example, Cu(In,Ga)(Se,S)₂(CIGS) has been employed as a light absorbing layer in commercial solar cells.

Efficiency of CIGS solar cell increased significantly in recent years after development of new methods to modify CIGS surface. One of the most prominent method is potassium post treatment (K-PDT) of CIGS surface (see, for example, Non-Patent Literatures 1 and 2). In the K-PDT method, thin potassium fluoride film is deposited on CIGS surface by vacuum co-evaporation. Subsequent heating and water washing modify composition at the outermost surface of CIGS to KInGaSeS.

Patent Literature 3 describes a method in which a KInSe₂ layer is formed on unmodified CIGS surface by vacuum deposition to obtain a similar surface state as in

Meanwhile, NaInS₂, KInS₂ and CaIn₂S₄ themselves are known as n-type semiconductors with visible light absorption. Specifically, for example, CaIn₂S₄ and NaInS₂/CuInS₂ powders are known to show visible light photocatalytic activity (see, for example, Non-Patent Literatures 4 and 5).

Many attempts have been made to prepare solutions that can give high quality metal chalcogenide films. To prepare a homogeneous solution, for example, metal oxide, metal sulfide and/or metal chloride are dissolved with chalcogens by amine and thiols (see, for example, Non-Patent Literature 6). To prepare a particle suspension, for example, metal chalcogenide nanocrystals capped with amines and thiols are suspended in organic solvents Non-Patent Literature 7.

### DOCUMENTS OF RELATED ART

### [Non-Patent Literature]

[Non-Patent Literature 1] Nature Materials 12, 1107-1111 (2013)
[Non-Patent Literature 2] Nano Letter, 2015, 15(5), pp 3334-3340
[Non-Patent Literature 3] IEEE Journal of Photovoltaics, Volume: 6, Issue: 5, pp. 1316-1320 (2016)
[Non-Patent Literature 4] Chem. Commun., 2015, 51, 9381-9384
[Non-Patent Literature 5] ACS Appl. Mater. Interfaces 2014, 6, 12877-12884
[Non-Patent Literature 6] Angew. Chem. Int. Ed. 2015, 54, 8378-8381
[Non-Patent Literature 7] Progress in Photovoltaics: Research and

### SUMMARY OF THE INVENTION

### Technical Problem

Although K-PDT and current KInS₂ deposition use vacuum deposition method, solution-processing of KInSe₂/KInS₂ layer is expected to have significant advantages for introduction of these methods to mass production with large area substrate.

Further, although the homogeneous solution described in Non-Patent Literature 6 and the dispersion described in Non-Patent Literature 7 are capable of readily dissolving its ingredients or suspending nanocrystals, carbon contamination after high temperature treatments under inert atmosphere is unavoidable due to strong coordination ability of amine and thiols in the solutions. Residual carbons in the coating film hamper crystal growth during heat treatment and degrade significantly its electrical properties. Solution that do not reside carbon and other contaminants in the coating film is highly desirable, but such kind of solution has not been developed yet.

The present invention takes the above circumstances into consideration, with an object of providing a homogeneous coating solution and a production method thereof which are advantageous in terms of high level of safety, low cost, and forming a light-absorbing layer containing high quality crystals.

### Solution to Problem

For solving the above-mentioned problems, the present invention employs the following embodiments.
(1) A homogeneous coating solution including: at least one metal or metal compound selected from the group consisting of a group 1 metal, a group 2 metal, a group 1 metal compound and a group 2 metal compound; at least one metal or metal compound selected from the group consisting of a group 13 metal and a group 13 metal compound; a Lewis base solvent; and a Lewis acid.
(2) The homogeneous coating solution according to item (1) above, which includes a compound represented by general formula (1) shown below:
   [Chemical Formula 1.]

   AₓB_{y}C_{z} ... (1)

   wherein A represents at least one metal selected from the group consisting of a group 1 metal and a group 2 metal; B represents at least one group 13 metal; C represents at least one group 16 element; 0 < x ≤ 1,0 < y ≤ 1, and 0 < z ≤ 2.
(3) The homogeneous coating solution according to item (2) above, wherein, in general formula (1), x/y > 0.1.
(4) The homogeneous coating solution according to any one of items (1) to (3) above, wherein the Lewis base solvent is an aprotic solvent.
(5) The homogeneous coating solution according to item (4) above, wherein the aprotic solvent is at least one member selected from the group consisting of dimethylsulfoxide, pyridine, tetramethylurea, tetrahydrofuran, ethyl acetate, acetone, dimethylformamide, acetonitrile, dichloromethane, dimethylacetoamide, N-methylpyrrolidone, N-methylimidazole and γ-butyrolactone.
(6) The homogeneous coating solution according to any one of items (1) to (5), wherein the Lewis acid is an onium salt.
(7) The homogeneous coating solution according to item (6) above, wherein the Lewis acid is an ammonium salt.
(8) The homogeneous coating solution according to item (7) above, wherein the ammonium salt is at least one member selected from the group consisting of ammonium hydroxide, ammonium sulfide, ammonium chloride, ammonium carbonate, ammonium selenide, ammonium thiocyanate, ammonium acetate, ammonium carbamate, ammonium formate, ammonium hexafluorophosphate, ammonium hydrogen difluoride and ammonium nitrate.
(9) The homogeneous coating solution according to any one of items (1) to (8) above, which further includes a group 16 element.
(10) The homogeneous coating solution according to item (9) above, wherein the group 16 element is at least one member selected from the group consisting of S, Se and Te.
(11) A method of producing a homogeneous coating solution, the method including: mixing together at least one metal or metal compound selected from the group consisting of a group 1 metal, a group 2 metal, a group 1 metal compound and a group 2 metal compound; at least one metal or metal compound selected from the group consisting of a group 13 metal and a group 13 metal compound; a Lewis base solvent; and a Lewis acid.
(12) The method according to item (11) above, wherein the homogeneous coating solution includes a compound represented by general formula (1) shown below:
   [Chemical Formula 2.]

   AₓB_{y}C_{z} ... (1)

   wherein A represents at least one metal selected from the group consisting of a group 1 metal and a group 2 metal; B represents at least one group 13 metal; C represents at least one group 16 element; 0 < x ≤ 1, 0< y < 1, and 0 < z ≤ 2.
(13) The method according to item (12) above, wherein, in general formula (1), x/y > 0.1.
(14) The method according to any one of items (11) to (13) above, wherein the Lewis base solvent is an aprotic solvent.
(15) The method according to item (14) above, wherein the aprotic solvent is at least one member selected from the group consisting of dimethylsulfoxide, pyridine, tetramethylurea, tetrahydrofuran, ethyl acetate, acetone, dimethylformamide, acetonitrile, dichloromethane, dimethylacetoamide, N-methylpyrrolidone, N-methylimidazole and γ-butyrolactone.
(16) The method according to any one of items (11) to (15) above, wherein the Lewis acid is an onium salt.
(17) The method according to item (16) above, wherein the Lewis acid is an ammonium salt.
(18) The method according to item (17) above, wherein the ammonium salt is at least one member selected from the group consisting of ammonium hydroxide, ammonium sulfide, ammonium chloride, ammonium carbonate, ammonium selenide, ammonium thiocyanate, ammonium acetate, ammonium carbamate, ammonium formate, ammonium hexafluorophosphate, ammonium hydrogen difluoride and ammonium nitrate.
(19) The method according to any one of items (11) to (18) above, further including mixing a group 16 element.
(20) The method according to item (19) above, wherein the group 16 element is at least one member selected from the group consisting of S, Se and Te.

Other embodiments of the present invention are as follows:
(21) A semiconductor layer formed by using the homogeneous coating solution according to any one of items (1) to (10) above.
(22) A solar cell including the semiconductor layer of item (11) above.
(23) A method of forming a visible light-absorbing semiconductor layer, the method including: applying a homogeneous coating solution according to any one of items (1) to (10) above to a base, followed by baking.
(24) A method of producing a solar cell, the method including: forming a first electrode on a substrate; applying a homogeneous coating solution according to any one of items (1) to (10) above to the first electrode, followed by baking to form a light-absorbing layer; forming a buffer layer on the light-absorbing layer; and forming a second electrode on the buffer layer.

### Advantageous Effects of Invention

According to the present invention, there are provided a homogeneous coating solution and a production method thereof which are advantageous in terms of high level of safety. Further, according to the present invention, there are also provided a homogeneous coating solution and a production method thereof which is capable of forming a semiconductor layer (light-absorbing layer) containing high quality crystals at low costs

### DETAILED DESCRIPTION OF THE INVENTION

### [Homogeneous coating solution and production method thereof]

Hereinbelow, the homogeneous coating solution and production method thereof according to the present embodiment will be described.

A homogeneous coating solution according to the present embodiment includes: at least one metal or metal compound selected from the group consisting of a group 1 metal, a group 2 metal, a group 1 metal compound and a group 2 metal compound (hereafter, sometimes collectively referred to as "IA/IIA metal and/or metal compound"); at least one metal or metal compound selected from the group consisting of a group 13 metal and a group 13 metal compound (hereafter, sometimes collectively referred to as "IIIA metal and/or metal compound"); a Lewis base solvent; and a Lewis acid.

In the present specification and claims, a "homogeneous solution" refers to a solution in which the solute (IA/IIA metal and/or metal compound, IIIA metal and/or metal compound, Lewis acid, group 16 element and any optional component) is homogeneously dissolved over the entire solvent (Lewis base solvent and any optional solvent), and does not include a dispersion solution in which metal particles and/or metal compound particles are dispersed in the solvent.

Examples of the group 1 metal include Li element, Na element, K element, Rb element and Cs element. Among these examples, Li element, Na element and K element are preferable.

Examples of the group 1 metal compound include Li₂O, Li₂S, Li₂Se, Li₂Te, LiF, LiCl, LiBr, LiI, LiNO₃, LiOH, Li₂CO₃, CH₃CO₂Li, Li₂SO₄, Li₂SO₃, Li₂S₂O₃, CH₃OLi, Na₂O, Na₂S, Na₂Se, Na₂Te, NaF, NaCl, NaBr, NaI, NaNO₃, NaOH, Na₂CO₃, CH₃CO₂Na, NaHCO₃, Na₂SO₄, Na₂SO₃, Na₂S₂O₃, Na₂S₂O₃, CH₃ONa, K₂S, K₂O, K₂Se, K₂Te, KF, KCl, KI, KBr, KNO₃, KOH, K₂CO₃, KHCO₃, K₂SO₄, K₂SO₃, K₂S₂O₃, CH₃CO₂K, CH₃OK, Rb₂O, Rb₂S, Rb₂Se, Rb₂Te, RbF, RbCl, RbBr, RbI, RbNO₃, RbOH, Rb₂CO₃, CH₃CO₂Rb, RbHCO₃, Rb₂SO₄, Rb₂SO₃, Rb₂S₂O₃, CH₃ORb, Cs₂O, Cs₂S, Cs₂Se, Cs₂Te, CsF, CsCl, CsBr, CsI, CsNO₃, CsOH, Cs₂CO₃, CH₃CO₂Cs, CsHCO₃, Cs₂SO₄, Cs₂SO₃, Cs₂S₂O₃ and CH₃OCs. Among these examples, Li₂S, Li₂Se, LiI, LiNO₃, LiOH, Na₂S, Na₂Se, NaI, NaNO₃, NaOH, CH₃CO₂K, K₂S, K₂Se, KI, KNO₃, KOH, Rb2ₛ, Rb₂Se, RbI, RbNO₃, RbOH, Cs₂S, Cs₂Se, CsI, CsNO₃ and CsOH are preferable.

Examples of group 2 element include Be element, Mg element, Ca element, Sr element and Ba element. Among these examples, Ca element is preferable.

Examples of group 2 metal compounds include BeS, BeSe, BeI₂, BeCl₂, Be(NO₃)₂, Be(OH)₂, MgO, MgS, MgSe, MgTe, MgF₂, MgCl₂, MgBr₂, MgI₂, Mg(NO₃)₂, Mg(OH)₂, MgSO₄, MgCO₃, Mg(HCO₃)₂, MgSO₃, MgS₂O₃, (CH₃CO₂)₂Mg, (CH₃O)₂Mg, CaO, CaS, CaSe, CaTe, CaF₂, CaCl₂, CaBr₂, Cal₂, Ca(NO₃)₂, Ca(OH)₂, CaSO₄, CaCO₃, Ca(HCO₃)₂, CaSO₃, CaS₂O₃, (CH₃CO₂)₂Ca, (CH₃O)₂Ca, SrO, SrS, SrSe, SrTe, SrF₂, SrCl₂, SrBr₂, SrI₂, Sr(NO₃)₂, Sr(OH)₂, SrSO₄, SrCO₃, Sr(HCO₃)₂, SrSO₃, SrS₂O₃, (CH₃CO₂)₂Sr, (CH₃O)₂Sr, BaO, BaS, BaSe, BaTe, BaF₂, BaCl₂, BaBr₂, BaI₂, Ba(NO₃)₂, Ba(OH)₂, BaSO₄, BaCO₃, Ba(HCO₃)₂, BaSO₃, BaS₂O₃, (CH₃CO₂)₂Ba, (CH₃O)₂Ba. Among these examples, BeS, BeSe, BeI₂, BeCl₂, Be(NO₃)₂, Be(OH)₂, MgS, MgSe, MgI₂, Mg(NO₃)₂, Mg(OH)₂, CaS, CaSe, CaI₂, Ca(NO₃)₂, Ca(OH)₂, CaS, SrS, SrSe, SrI₂, Sr(NO₃)₂, Sr(OH)₂, BaS, BaSe, BaI₂, Ba(NO₃)₂ and Ba(OH)₂ are preferable.

As the IA/IIA metal and/or metal compound, LiI, Li₂S, LiOH, LiCl, Na₂S, NaOH, NaCl, K₂S, KOH, KCl, Rb₂S, RbOH, RbCl, Cs₂S, CsOH, CsCl, BeS, Be(OH)₂, BeCl₂, MgS, Mg(OH)₂, MgCl₂, CaS, Ca(OH)₂, CaCl₂, SrS, Sr(OH)₂, SrCl₂, BaS, Ba(OH)₂ and BaCl₂ are preferable, and LiI, K₂S, Na₂S and CaS are more preferable.

As the IA/IIA metal and/or compound, one kind of compound may be used, or two or more kinds of compounds may be used in combination.

Examples of the group 13 metal include Al element, Ga element and In element. Among these examples, Ga element and In element are preferable.

Examples of the group 13 metal compound include In(OH)₃, indium oxide, indium sulfide, indium selenide, indium telluride, Ga(OH)₃, gallium oxide, gallium sulfide, gallium selenide, gallium telluride, indium gallium hydroxide, boric acid and boron oxide. Among these examples, In(OH)₃, indium oxide, indium sulfide, indium selenide, Ga(OH)₃, gallium oxide, gallium sulfide, gallium selenide and indium gallium hydroxide are preferable.

As the IIIA metal and/or metal compound, Al element, Ga element, In element, In(OH)₃, indium oxide and gallium oxide are preferable, and Ga element and In element are more preferable.

As the IIIA metal and/or compound, one kind of compound may be used, or two or more kinds of compounds may be used in combination.

The Lewis base solvent is not particularly limited, as long as it is a substance capable of dissolving the IA/IIA metal and/or metal compound, the IIIA metal and/or metal compound, the Lewis acid, and any optional component, and donating an electron pair.

As the Lewis base solvent, an aprotic solvent is preferable. Examples of the aprotic solvent include dimethylsulfoxide, pyridine, tetramethylurea, tetrahydrofuran, ethyl acetate, acetone, dimethylformamide, acetonitrile, dichloromethane, dimethylacetoamide, N-methylpyrrolidone and N-methylimidazole and γ-butyrolactone.

Among these examples, dimethylsulfoxide, tetramethylurea or γ-butyrolactone is preferable, and dimethylsulfoxide is more preferable.

As the Lewis base solvent, one type of compound may be used alone, or two or more types of compounds may be used in combination.

The Lewis acid is not particularly limited as long as it is a substance capable of accepting an electron pair.

As the Lewis acid, an onium salt is preferable. Examples of onium salt include an ammonium salt [(NH₄)⁺], a phosphonium salt [(PH₄)⁺], a sulfonium salt [(H₃S)⁺], a methanium salt [(CH₅)]⁺, a boronium salt [(BH₃)⁺, (BH₄)⁺, (BH₅)⁺, (BH₆)⁺], a disilanium salt [(Si₂H₇)⁺] and a germonium salt [(GeH₅)⁺], Among these examples, an ammonium salt is preferable.

Examples of ammonium salt include ammonium hydroxide, ammonium sulfide, ammonium chloride, ammonium carbonate, ammonium selenide, ammonium thiocyanate, ammonium acetate, ammonium carbamate, ammonium formate, ammonium hexafluorophosphate, ammonium hydrogen difluoride and ammonium nitrate. Among these examples, ammonium hydroxide, ammonium sulfide or a combination thereof is preferable.

As the Lewis acid, one type of compound may be used alone, or two or more types of compounds may be used in combination.

The homogeneous coating solution according to the present embodiment may include a group 16 element. Examples of group 16 element include O, S, Se and Te. As the group 16 element, at least one member selected from the group consisting of S, Se and Te is preferable, and S and Se is more preferable.

As the group 16 element, one kind of element may be used alone, or two or more kinds of elements may be used in combination. Alternatively, among the aforementioned IA/IIA metal and/or metal compounds, IIIA metal and/or metal compounds and Lewis acid, compounds containing a group 16 element may be used.

In the present embodiment, the homogeneous solution may contain a solvent other than Lewis base solvent (hereafter, referred to as "optional solvent"). As the optional solvent, water, an alcohol (e.g., methanol, ethanol or propanol), a glycol (e.g., ethylene glycol or propylene glycol) and a glycolether (e.g., methyldiglycol) can be mentioned.

As the optional solvent, one kind of solvent may be used alone, or two or more kinds of solvents may be used in combination.

In the present embodiment, a solvent having a polarity lower than the polarity of the Lewis base solvent (hereafter, sometimes referred to as "poor solvent") may be added to the homogeneous coating solution. By adding a poor solvent, the homogeneous coating solution can be purified, and impurities can be removed. However, in the present embodiment, such purification step is not always necessary. By omitting such purification step, the entire process of the method can be simplified, which results in industrial advantages.

The poor solvent is not particularly limited as long as it is a solvent having a polarity lower than the polarity of the Lewis base solvent, and acetone and isopropanol is preferable.

The poor solvent may be mixed together with the metal and/or metal compound, the Lewis base solvent, the Lewis acid and optionally the group 16 element in the preparation of the homogeneous coating solution; however, it is preferable to add the poor solvent to the homogeneous coating solution after the preparation thereof. By mixing the poor solvent after preparing the homogeneous coating solution, the objective complex can be precipitated, and impurities such as unreacted S or Se can be removed as a supernatant. The complex and the impurities can be separated by centrifugal separation, filtration, extraction or the like.

After removing the impurities as a supernatant, the complex may be further washed with a poor solvent. By conducting the washing a plurality of times, the impurities can be more reliably removed.

As the poor solvent, one kind of solvent may be used alone, or two or more kinds of solvents may be used in combination.

The homogeneous coating solution according to the present embodiment preferably includes a compound represented by general formula (1) shown below.

[Chemical Formula 3.]

AₓB_{y}C_{z} ... (1)

wherein A represents at least one metal selected from the group consisting of a group 1 metal and a group 2 metal; B represents at least one group 13 metal; C represents at least one group 16 element; 0 < x ≤ 1, 0 < y ≤ 1, and 0 < z ≤ 2.

In general formula (1), A represents at least one metal selected from the group consisting of a group 1 metal and a group 2 metal, preferably at least one member selected from the group consisting of Li element, Na element, K element and Ca element.

In general formula (1), B represents at least one group 13 metal, preferably at least one member selected from the group consisting of Ga element and In element.

In general formula (1), C represents at least one group 16 element, preferably at least one member selected from the group consisting of S, Se and Te, and more preferably at least one member selected from the group consisting of S and Se.

In general formula (1), 0 < x ≤ 1, preferably 0.5 ≤ x ≤ 1.

In general formula (1), 0 < y ≤ 1, preferably 0.5 ≤ y ≤ 1.

In general formula (1), 0 < z ≤ 2, preferably 1 ≤ z ≤ 2.

In general formula (1), it is preferable that x/y > 0.1, more preferably x/y ≥ 0.2, still more preferably x/y ≥ 0.3, and most preferably x/y ≥ 0.4. The upper limit of the x/y ratio is not particularly limited, but is preferably x/y ≤ 3.0, more preferably x/y ≤ 2.9, and still more preferably x/y ≤ 2.8.

In general formula (1), in the case where A represents a group 1 metal, it is preferable that 0.4 ≤ x/y ≤ 3.0, more preferably 0.5 ≤ x/y ≤ 2.5, still more preferably 0.6 ≤ x/y ≤ 1.8, and most preferably 0.8 ≤ x/y ≤ 1.5.

In general formula (1), in the case where A represents a group 2 metal, it is preferable that 0.3 ≤ x/y ≤ 1.0, more preferably 0.4 ≤ x/y ≤ 0.8, still more preferably 0.4 ≤ x/y ≤ 0.7, and most preferably 0.4 ≤ x/y ≤ 0.6.

In the case where the homogeneous coating solution of the present embodiment contains at least two kinds of IIIA metals and/or metal compounds, the homogeneous coating solution preferably includes a compound represented by general formula (2) shown below.

[Chemical Formula 4.]

Aₓ(B1₁₋ᵤ-B2ᵤ)_{y}C_{z} ... (2)

wherein A represents at least one metal selected from the group consisting of a group 1 metal and a group 2 metal; B1 and B2 each independently represents a group 13 metal, provided that B1 and B2 are different; C represents at least one group 16 element; 0 < x ≤ 1,0 < y ≤ 1,0 < z ≤ 2,0 < u ≤ 1.

In general formula (2), A, C, x, y and z are the same as defined for A, C, x, y and z in general formula (1), respectively.

In general formula (2), B1 and B2 each independently represents a group 13 metal, provided that B1 and B2 are different. B1 is preferably In element, and B2 is preferably Ga element.

In general formula (2), 0 < u ≤ 1, preferably 0.1 ≤ x ≤ 0.5.

The homogeneous coating solution according to the present embodiment is obtainable by mixing together the IA/IIA metal and/or metal compound, the IIIA metal and/or metal compound, the Lewis base solvent, the Lewis acid and any optional component. The method of mixing the materials is not particularly limited. For example, all of the raw materials may be mixed together at once, or part of the raw materials may be mixed, and then the remainder of the raw materials may be added thereto.

As the IA/IIA metal and/or metal compound, the IIIA metal and/or metal compound, the Lewis base solvent, the Lewis acid and the group 16 element usable as the raw materials, the same IA/IIA metals and/or metal compounds, IIIA metals and/or metal compounds, Lewis base solvents, Lewis acids and group 16 elements as those described above in relation to the homogeneous coating solution may be used.

The amount of each raw material may be appropriately adjusted depending on the kind of raw materials used.

The amount of the IA/IIA metal and/or metal compound per 1 mol of the IIIA metal and/or metal compound is preferably more than 0.1 mol, more preferably 0.2 mol or more, still more preferably 0.3 mol or more, and most preferably 0.4 mol or more. The upper limit of the amount of the IA/IIA metal and/or metal compound per 1 mol of the IIIA metal and/or metal compound is preferably 3.0 mol or less, more preferably 2.9 mol or less, and still more preferably 2.8 mol or less.

More specifically, in the case where a group 1 metal and/or a group 1 metal compound is used as the IA/IIA metal and/or metal compound, the amount of the IA/IIA metal and/or metal compound per 1 mol of the IIIA metal and/or metal compound is preferably in the range of 0.4 to 3.0 mol, more preferably 0.5 to 2.5 mol, still more preferably 0.6 to 1.8 mol, and most preferably 0.8 to 1.5 mol. In the case where a group 2 metal and/or a group 2 metal compound is used as the IA/IIA metal and/or metal compound, the amount of the IA/IIA metal and/or metal compound per 1 mol of the IIIA metal and/or metal compound is preferably in the range of 0.3 to 1.0 mol, more preferably 0.4 to 0.8 mol, still more preferably 0.4 to 0.7 mol, and most preferably 0.4 to 0.6 mol.

The amount of the Lewis acid per 1 mol of the total of the IA/IIA metal and/or metal compound and the IIIA metal and/or metal compound is preferably 0.1 to 2.0 mol, more preferably 0.1 to 1.2 mol, and still more preferably 0.3 to 0.8 mol.

When a group 16 element is used, the amount of the group 16 element per 1 mol of the total of the IA/IIA metal and/or metal compound and the IIIA metal and/or metal compound is preferably 0 to 15 mol, more preferably 1 to 10 mol, and still more preferably 2 to 5 mol.

In the present embodiment, the method of mixing the raw materials is not particularly limited. Examples of the method for mixing include a method in which the Lewis acid and optionally the group 16 element are added to the Lewis base solvent and stirred, followed by addition of the IA/IIA metal and/or metal compound and the IIIA metal and/or metal compound; a method in which the IA/IIA metal and/or metal compound, the IIIA metal and/or metal compound, Lewis acid and optionally the group 16 element are added to a Lewis base solvent, followed by stirring; and a method in which the IA/IIA metal and/or metal compound, the IIIA metal and/or metal compound, Lewis acid and optionally the group 16 element are mixed together, followed by addition of a Lewis base solvent. In the present embodiment, the method in which the Lewis acid and optionally the group 16 element are added to the Lewis base solvent and stirred, followed by addition of the IA/IIA metal and/or metal compound and the IIIA metal and/or metal compound is preferable.

The amount of the solvent depends on the kind of raw materials used. However, the solvent is preferably used in an amount such that the solid content becomes 1 to 30% by weight, more preferably 5 to 20% by weight, provided that the solid content is the residual content after heating at 500°C in a thermogravimetric analysis.

In the method of the present embodiment, the reaction temperature varies depending on the kind of raw materials used. However, in general, in terms of safety and stability of the complex, the reaction temperature is preferably from 0°C to 200°C, more preferably from room temperature to 150°C, and still more preferably from room temperature to 100°C.

In the method of the present embodiment, the reaction time varies depending on the types of raw materials used, and the stirring time. However, in general, the reaction time is preferably from 1 hour to 2 weeks, more preferably from 1 day to 1 week, and still more preferably from 1 to 4 days.

In the present embodiment, a binary or ternary metal complex solution can be obtained, for example, by mixing together a IA/IIA metal and/or metal compound, at least two kinds of IIIA metals and/or metal compounds, a Lewis base solvent, a Lewis acid and optionally a group 16 element. In such a case, the homogeneous coating solution preferably contains a compound represented by the aforementioned general formula (2).

Further, in the present embodiment, 2 or more homogenous coating solutions containing different kinds of IA/IIA metals and/or IIIA metals may be prepared separately as metal precursor solutions, and then the metal precursor solutions may be mixed together to obtain a single homogeneous coating solution.

In the present embodiment, since no hydrazine is used in the homogeneous coating solution, the safety in process is improved. Further, in the present embodiment, the homogeneous coating solution can be prepared with ease at a low cost. In addition, in the present embodiment, since no organic ligand is used in the homogeneous coating solution, a semiconductor layer can be formed in which the amount of organic substance that becomes a cause of inhibiting the crystal growth is reduced. In addition, the homogeneous coating solution according to the present embodiment is usable as a dopant for a CIGS layer to help grain growth.

### [Semiconductor layer, and production method thereof]

The semiconductor layer according to another embodiment is formed using the homogeneous coating solution of the present embodiment. The semiconductor is, for example, a light-absorbing layer for a wavelength ranging from ultraviolet to far-infrared, and is preferably a visible light-absorbing semiconductor layer.

The method of forming a semiconductor layer according to another embodiment is the same as the step of forming a light-absorbing layer in the method of forming a solar cell according to another embodiment.

### [Solar cell and production method thereof]

The method of producing a solar cell according to the present embodiment includes: forming a first electrode on a substrate; applying a homogeneous coating solution according to the present embodiment to the first electrode, followed by baking to form a light-absorbing layer; forming a buffer layer on the light-absorbing layer; and forming a second electrode on the buffer layer.

In the method of forming a solar cell according to the present embodiment, the steps other than the step of forming a light-absorbing layer on the first electrode may be performed by any conventional method. For example, the step of forming a first electrode on a substrate may be performed by a sputtering method using nitrogen as a sputtering gas, and forming a film layer such as an Mo layer. The buffer layer may be formed as a CdS layer by, for example, a chemical bath deposition method. The second electrode may be formed as a transparent electrode using an appropriate material.

In the formation of a light-absorbing layer, firstly, a homogeneous coating solution according to the present embodiment is applied to the first electrode (base). The application of the coating solution may be conducted by a spin-coat method, a dip-coat method, a doctor-blade (applicator) method, a curtain-slit cast method, a printing method, a spraying method or the like. In the present embodiment, in terms of mass production, it is preferable to use a non-spin coat method.

The application conditions may be appropriately selected depending on the desired film thickness, concentration of the materials and the like.

For example, in a spin-coating method, the base is set on a spin coater, followed by applying the homogeneous coating solution to the base. The application conditions may be appropriately selected depending on the film thickness. For example, the application may be performed at a rotation speed of 300 to 3,000 rpm for 10 to 180 seconds. The application may be repeatedly performed until a desired thickness is obtained.

Alternatively, in a non-spin coating method, the homogeneous coating solution is applied from a slit nozzle having a rectangular ejection nozzle. The number of times the application is conducted is not particularly limited, preferably 1 to 10 times, and more preferably 1 to 5 times.

In a dipping method, the base may be dipped in a container containing the homogeneous coating solution. The dipping may be performed once, or a plurality of times.

After applying the homogeneous coating solution for forming a light-absorbing layer on the base, a vacuum drying may be performed.

Subsequently, after applying the homogeneous coating solution on the support, the support is baked to form a light-absorbing layer.

The baking conditions may be appropriately selected depending on the desired film thickness, the kind of materials used, and the like. For example, the baking may be performed in 2 steps, namely, performing a soft bake on a hot plate (prebake), followed by baking in an oven (annealing).

In such a case, for example, the base may be set and held on a hot plate, followed by raising the temperature of the hot plate to 100 to 500°C to perform the soft bake for 1 to 300 seconds. Then, the base is cooled to room temperature, and application is performed again. After obtaining the desired film thickness, the hot plate or the inside of the oven is heated to 300 to 700°C and maintained for 1 to 180 minutes to perform the annealing.

As a result, the light-absorbing layer is cured.

The baking temperatures described above are merely one example of the baking conditions, and the baking conditions are not particularly limited. For example, the temperature of the hot plate may be raised in a stepwise manner, and the heating may be performed in an inert gas atmosphere in a glove box. Further, soft bake or anneal may be performed in an atmosphere in the presence of hydrogen sulfide, hydrogen selenide, solid sulfur or solid selenium. However, in the present embodiment, by using, as the Lewis acid, a compound functioning as a chalcogen source, a light-absorbing layer having a desired structure may be formed even when soft bake and/or annealing is conducted in an atmosphere absent of hydrogen sulfide, hydrogen selenide, solid sulfur, solid selenium or the like.

In the case where two or more kinds of binary or ternary metal complex solutions are used, a first complex solution may be applied to the base, followed by baking to form a first layer, and then a second complex solution having a different metal composition from that of the first complex solution may be applied to the first layer, followed by baking to form a second layer. Thereafter, the first and second layers may be annealed to thereby form a single light-absorbing layer having a desired composition, or a multilayer-structured light-absorbing layer having a desired gradation in the metal composition ratios. In such a case, it is expected that the arrangement of the metal in the light-absorbing layer may be reliably designed, and the structure of the light-absorbing layer may be reliably controlled.

However, it should be noted that stacking of complex solutions (coating films) with different compositions is not limited to the case where two or more kinds of binary or ternary metal complex solutions are used. Even when unary complex solutions are used, complex solutions with different compositions may be stacked in any desired order. In this manner, a flexible design of composition profile within the coating film may be facilitated.

In this manner, a solar cell according to the present embodiment can be produced. Since the solar cell produced by the method of the present embodiment contains no hydrazine in the homogeneous coating solution, the safety of the production process may be improved. In addition, since no organic ligand is used in the homogeneous coating solution, the amount of organic substance that becomes a cause of inhibiting the crystal growth is reduced in the light-absorbing layer. As a result, an excellent crystal growth may be obtained.

### EXAMPLES

As follows is a description of examples of the present invention, although the scope of the present invention is by no way limited by these examples.

### [Production of homogeneous coating solution]

### (Example 1)

1.28 g (40.00 mmol) of S (sulfur), 25.00 g of DMSO (dimethylsulfoxide), 3.238g (20.00mmol in terms of S) of a 42% aqueous (NH₄)₂S (ammonium sulfide) solution and 2.311 g (38.00mmol in terms of NH₃) of a 28wt% aqueous NH₃ solution were mixed together, followed by stirring at room temperature over one night.

To the obtained reaction liquid was added 1.553 g (13.50 mmol) of In, 0.105 g (1.50 mmol) of Ga, followed by stirring at room temperature for 2 days. Thereafter, 1.985 g (18.00 mmol) of K₂S was added, followed by stirring at room temperature for 2 days, thereby obtaining homogeneous coating solution 1.

### (Examples 2 to 17)

Homogeneous coating solutions 2 to 17 were produced in the same manner as in Example 1, except that the kind of compounds and amounts thereof were changed to those indicated in Table 1 shown below.

### (Example 18)

To 21.19 g of dimethylsulfoxide (DMSO) were mixed 1.148 g (10 mmol) of In, 0.64 g (20.00 mmol) of sulfur (S) and 2.042 g (12.5 mmol in terms of S) of a 42% aqueous (NH₄)₂S (ammonium sulfide) solution, followed by stirring at room temperature for 24 hours.

In the mixed solution obtained after the stirring, a potassium hydroxide solution (concentration: 28% by weight; 6.0mmol in terms of K; indicated as "KOH" in Table 1) was dissolved, thereby obtaining homogeneous coating solution 18.

### (Example 19)

Homogenous coating solution 19 was produced in the same manner as in Example 18, except that the potassium hydroxide solution was changed to 0.59g of a potassium acetate powder (6.00 mmol in terms of K; indicted as "K(Ace)" in Table 1).

**[Table 1]**

| | Group 1 or 2 metal/metal compound (mmol) | Group 13 metal/metal compound | | Group 16 element | | DMSO (g) | NH₃ (mmol) | (NH₄)₂S (mmol) |
|---|---|---|---|---|---|---|---|---|
| | | In (mmol) | Ga (mmol) | S (mmol) | Se (mmol) | | | |
| Ex. 1 | K₂S (18.00) | 13.50 | 1.50 | 40.00 | - | 25.00 | 38.00 | 20.00 |
| Ex. 2 | K₂S(13.50) | 13.50 | 1.50 | - | 50.00 | 23.00 | 102.00 | 12.00 |
| Ex. 3 | LiI (15.00) | 15.00 | | 40.00 | | 25.00 | 38.00 | 20.00 |
| Ex. 4 | LiI (20.00) | 10.00 | | 40.00 | | 25.00 | 38.00 | 20.00 |
| Ex. 5 | LiI (15.00) | 15.00 | | | 50.00 | 23.00 | 102.00 | 12.00 |
| Ex. 6 | LiI (15.00) | 9.00 | 6.00 | 40.00 | | 25.00 | 38.00 | 20.00 |
| Ex. 7 | LiI (15.00) | 13.50 | 1.50 | | 50.00 | 23.00 | 102.00 | 12.00 |
| Ex. 8 | Na₂S (15.00) | 15.00 | | 40.00 | | 25.00 | 38.00 | 20.00 |
| Ex. 9 | Na₂S (15.00) | 15.00 | | | 50.00 | 23.00 | 102.00 | 12.00 |
| Ex. 10 | Na₂S (15.00) | 9.00 | 6.00 | 40.00 | | 25.00 | 38.00 | 20.00 |
| Ex. 11 | Na₂S (15.00) | 13.50 | 1.50 | | 50.00 | 23.00 | 102.00 | 12.00 |
| Ex. 12 | K₂S (15.00) | 15.00 | | 40.00 | | 25.00 | 38.00 | 20.00 |
| Ex. 13 | K₂S (8.00) | 15.00 | | 40.00 | | 25.00 | 38.00 | 20.00 |
| Ex. 14 | K₂S (15.00) | 15.00 | | | 50.00 | 23.00 | 102.00 | 12.00 |
| Ex. 15 | K₂S (15.00) | 9.00 | 6.00 | 40.00 | | 25.00 | 38.00 | 20.00 |
| Ex. 16 | K₂S (15.00) | 13.50 | 1.50 | | 50.00 | 23.00 | 102.00 | 12.00 |
| Ex. 17 | CaS (15.00) | 15.00 | | 40.00 | | 25.00 | 38.00 | 20.00 |
| Ex. 18 | KOH (6.0) | 10.0 | - | 20.0 | - | 21.19 | - | 12.5 |
| Ex. 19 | K(Ace) (6.0) | 10.0 | - | 20.0 | - | 21.19 | - | 12.5 |

### [Production of semiconductor layer]

### (Example 20)

The homogeneous coating solution 1 prepared in Example 1 was applied to a glass substrate having Mo deposited thereon, followed by heating at 450°C for 8 minutes, so as to form a semiconductor layer.

The obtained semiconductor layer was subjected to an XRD measurement. As a result, at about 2θ = 11.98°, 24.57° and 31.36°, significant peaks ascribed to KInS₂ on (0,0,2) plane, (-2,2,2) plane and (-2,2,4) plane were observed, respectively. These results showed good consistency with conventionally known results of KInS₂ films (for example, see ICDD (PDF-2/Release 2012 RDB). Thus, it was confirmed that a KInS₂ film was formed. Regarding homogeneous coating solutions 2, 12 to 16, 18 and 19 produced in Examples 2, 12 to 16, 18 and 19, it was also confirmed that a KInS₂ film was formed.

While preferred embodiments of the invention have been described and illustrated above, it should be understood that these are exemplary of the invention and are not to be considered as limiting. Additions, omissions, substitutions, and other modifications can be made without departing from the spirit or scope of the present invention. Accordingly, the invention is not to be considered as being limited by the foregoing description, and is only limited by the scope of the appended claims.

## Claims

1. A homogeneous coating solution comprising:
at least one metal or metal compound selected from the group consisting of a group 1 metal, a group 2 metal, a group 1 metal compound and a group 2 metal compound;
at least one metal or metal compound selected from the group consisting of a group 13 metal and a group 13 metal compound;
a Lewis base solvent; and
a Lewis acid.

2. The homogeneous coating solution according to Claim 1, which comprises a compound represented by general formula (1) shown below:
[Chemical Formula 1]
AₓB_{y}C_{z} ... (1)
wherein A represents at least one metal selected from the group consisting of a group 1 metal and a group 2 metal; B represents at least one group 13 metal; C represents at least one group 16 element; 0 < x ≤ 1,0 < y ≤ 1, and 0 < z ≤ 2.

3. The homogeneous coating solution according to Claim 2, wherein, in general formula (1), x/y > 0.1.

4. The homogeneous coating solution according to any one of Claims 1 to 3, wherein the Lewis base solvent is an aprotic solvent.

5. The homogeneous coating solution according to Claim 4, wherein the aprotic solvent is at least one member selected from the group consisting of dimethylsulfoxide, pyridine, tetramethylurea, tetrahydrofuran, ethyl acetate, acetone, dimethylformamide, acetonitrile, dichloromethane, dimethylacetoamide, N-methylpyrrolidone, N-methylimidazole and γ-butyrolactone.

6. The homogeneous coating solution according to any one of Claims 1 to 5, wherein the Lewis acid is an onium salt.

7. The homogeneous coating solution according to Claim 6, wherein the Lewis acid is an ammonium salt.

8. The homogeneous coating solution according to Claim 7, wherein the ammonium salt is at least one member selected from the group consisting of ammonium hydroxide, ammonium sulfide, ammonium chloride, ammonium carbonate, ammonium selenide, ammonium thiocyanate, ammonium acetate, ammonium carbamate, ammonium formate, ammonium hexafluorophosphate, ammonium hydrogen difluoride and ammonium nitrate.

9. The homogeneous coating solution according to any one of Claims 1 to 8, which further comprises a group 16 element.

10. The homogeneous coating solution according to Claim 9, wherein the group 16 element is at least one member selected from the group consisting of S, Se and Te.

11. A method of producing a homogeneous coating solution, the method comprising:
mixing together at least one metal or metal compound selected from the group consisting of a group 1 metal, a group 2 metal, a group 1 metal compound and a group 2 metal compound;
at least one metal or metal compound selected from the group consisting of a group 13 metal and a group 13 metal compound;
a Lewis base solvent; and
a Lewis acid.

12. The method according to Claim 11, wherein the homogeneous coating solution comprises a compound represented by general formula (1) shown below:
[Chemical Formula 2]
AₓB_{y}C_{z} ... (1)
wherein A represents at least one metal selected from the group consisting of a group 1 metal and a group 2 metal; B represents at least one group 13 metal; C represents at least one group 16 element; 0 < x ≤ 1, 0< y ≤ 1, and 0 < z ≤ 2.

13. The method according to Claim 12, wherein, in general formula (1), x/y > 0.1.

14. The method according to any one of Claims 11 to 13, wherein the Lewis base solvent is an aprotic solvent.

15. The method according to Claim 14, wherein the aprotic solvent is at least one member selected from the group consisting of dimethylsulfoxide, pyridine, tetramethylurea, tetrahydrofuran, ethyl acetate, acetone, dimethylformamide, acetonitrile, dichloromethane, dimethylacetoamide, N-methylpyrrolidone, N-methylimidazole and γ-butyrolactone.

16. The method according to any one of Claims 11 to 15, wherein the Lewis acid is an onium salt.

17. The method according to Claim 16, wherein the Lewis acid is an ammonium salt.

18. The method according to Claim 17, wherein the ammonium salt is at least one member selected from the group consisting of ammonium hydroxide, ammonium sulfide, ammonium chloride, ammonium carbonate, ammonium selenide, ammonium thiocyanate, ammonium acetate, ammonium carbamate, ammonium formate, ammonium hexafluorophosphate, ammonium hydrogen difluoride and ammonium nitrate.

19. The method according to any one of Claims 11 to 18, further comprising mixing a group 16 element.

20. The method according to Claim 19, wherein the group 16 element is at least one member selected from the group consisting of S, Se and Te.
